**Europäisches Patentamt**

**European Patent Office**

**Office européen des brevets**

(11) Publication number: **0 136 106**
**B1**

## (12) EUROPEAN PATENT SPECIFICATION

(45) Date of publication of patent specification: **17.10.90**

(21) Application number: **84305917.1**

(22) Date of filing: **30.08.84**

(51) Int. Cl.⁵: **G 11 C 11/40**

(54) **Static random-access memory device.**

(30) Priority: **12.09.83 JP 167841/83**

(43) Date of publication of application:
**03.04.85 Bulletin 85/14**

(45) Publication of the grant of the patent:
**17.10.90 Bulletin 90/42**

(84) Designated Contracting States:
**DE FR GB NL**

(56) References cited:
**NEC RESEARCH & DEVELOPMENT, no. 32,
January 1974, pages 19-25, Tokyo, JP; S.
SUZUKI et al.: "A static RAM with normally-off-
type Schottky barrier FET's"**

**ELECTRONIC DESIGN, vol. 27, no. 7, 29th March
1979, pages 118-123, Denver, US; "Get top
memory system performance at low power
levels with MOS RAMs"**

(73) Proprietor: **KABUSHIKI KAISHA TOSHIBA
72, Horikawa-cho Saiwai-ku
Kawasaki-shi Kanagawa-ken 210 (JP)**

(72) Inventor: **Kanazawa, Katsue
1-1 Shibaura 1-chome Minato-ku
Tokyo (JP)**
Inventor: **Toyoda, Nobuyuki
1-1 Shibaura 1-chome Minato-ku
Tokyo (JP)**
Inventor: **Hojo, Akimichi
1-1 Shibaura 1-chome Minato-ku
Tokyo (JP)**

(74) Representative: **Shindler, Nigel et al
BATCHELLOR, KIRK & CO. 2 Pear Tree Court
Farringdon Road
London EC1R 0DS (GB)**

(56) References cited:
**IEEE TRANSACTIONS ON ELECTRON DEVICES,
vol. ED-30, no. 7, July 1982, pages 1110-1115,
IEEE, New York, US; G. BERT et al.: "High-speed
GaAs static random-access memory"**

Courier Press, Leamington Spa, England.

56 References cited:
PATENTS ABSTRACTS OF JAPAN, vol. 1, no. 50,
16th May 1977, page 3343 E 76; & JP - A - 51 147
224 (HITACHI SEISAKUSHO K.K.) 17-12-1976

GaAs IC SYMPOSIUM, Technical Digest 1983,
25th-27th October 1983, Phoenix, Arizona,
pages 86-89, US; N. TOYODA et al.: "A 256x4 bit
GaAs static RAM"

## Description

The present invention relates to a static random-access memory device formed by Schottky barrier gate field-effect transistors on a gallium arsenide substrate.

Schottky barrier gate field-effect transistors (hereinafter referred to as "MESFET") on a gallium arsenide substrate are known for their high speed operation. Accordingly, a high speed memory device, such as a static random-access memory device, can be fabricated by integrating a number of MESFETs on a gallium arsenide substrate. A static random-access memory device formed by such MESFETs has a matrix of memory cells, each memory cell including a flip-flop and a pair of transfer gases. The flip-flops include a pair of cross-coupled normally-off switching MESFETs connected to a pair of normally-on load MESFETs. The transfer gates are normally-off MESFETs which are connected to input/output nodes of the flip-flop. The gates of the MESFETs which constitute the transfer gates are coupled to word lines and the source or drains of these MESFETs are connected to bit lines. The word lines receive control signals from an X-addressing circuit constituted by MESFETs. The bit lines receive date through a MESFET switching circuit having gates connected to receive control signals from a Y-addressing circuit. The memory cells are read through the bit lines by a sense amplifier.

In the above high speed memory device, the memory cells, X- and Y-addressing circuits and the sense amplifier are usually energised by a common power supply. However, it has been found that, when the voltage of the common power supply is selected to be about 2 volts, the data stored in the memory cells can be easily destroyed by external disturbances such as power apply voltage changes, or this data may not be readable by the sense amplifier.

Accordingly, the present invention seeks to provide a static random-access memory device formed on a gallium arsenide substrate which is stable and has high speed operating capability.

The present invention also seeks to provide a static random-access memory device which is not susceptible to the destruction of data stored in the memory cells.

The present invention also seeks to provide a static random-access memory device in which the data stored in the memory cells can be easily and reliably read out by a sense amplifier.

Accordingly the applicants have conducted studies to determine the possible causes of data destruction and data read-out failure in static random-access memory devices (SRAM) constituted by MESFETs formed on a gallium arsenide substrate. It has been found that, when a control signal of a positive voltage higher than the forward breakdown voltage of a Schnottky barrier gate, for example 0.8 V, is applied to each of the gates of the MESFETs constituting the transfer gates in the memory cells and/or the MESFETs constituting the switching circuit connected to the bit lines, a current flows from the gates of the MESFETs into their sources or drains to change the potential at either the input/output nodes of the flip-flop of each memory cell or the bit lines. However, it has been determined that this control signal votlage can be eliminated by connecting a Schottky barrier gate diode in a forward bias direction between a reference potential and at least one of the word lines to clamp the gate voltage of the MESFET constituting the transfer gate.

An arrangement of this kind, in which a Schottky barrier gate diode is connected in a forward bias mode between the word line and a reference potential, is shown in IEEE Transactions on Electron Device, Vol. ED-30 No. 7, July 1982 pages 1110—1115.

The applicants have now determined that a further improvement can be obtained by connecting a further Schottky barrier gate diode between the reference potential and at least one of the drive lines connected to the gates of the MESFETs forming the switching circuit for actuating the bit lines.

Accordingly the present invention provides a static random-access memory device which is formed on a gallium arsenide substrate comprising:

(a) a plurality of memory cells connected in a matrix by bit lines and word lines each memory cell including a flip-flop having a pair of input/output nodes and a pair of cross-coupled normally-off Schottky barrier gate field-effect transistors connected to said input/output nodes, said memory cell further including a pair of transfer gates formed by normally-off Schottky barrier gate field-effect transistors having their gates connected to said word lines and their sources and drains connected between said input/output nodes of said flip-flop and said bit lines;

(b) first addressing circuit means for supplying control signals to said transfer gates through said word lines;

(c) data input means for writing data into said memory cells through said bit lines;

(d) data output means for reading data out of said memory cells through said bit lines;

(e) switching means formed by normally-off Schottky barrier gate field-effect transistors for selecting said bit lines;

(f) second addressing circuit means for supplying control signals through drive lines to said switching means;

(g) a first Schottky barrier gate diode connected in a forward bias direction between at least one of said word lines and a reference potential to clamp the gate voltage on the gates of said Schottky barrier gate field-effect transistors forming said transfer gates; and

(h) a second Schottky barrier gate diode connected in a forward bias direction between at least one of said drive lines and said reference potential to clamp the gate voltage on the gates of said Schottky barrier gate field-effect transistors forming said switching means.

In the memory device of the present invention, current flow from the word line into the sources or drains of the MESFETs of the transfer gates is prevented. Current flow is also prevented from the drive lines into the sources or drains of the MESFETs of the switching circuits for selecting the bit lines. It is noted that, since it is necessary to turn on the MESFETs of the transfer gates and the switching circuits, the forward breakdown voltage of the Schottky barrier gate diodes must be equal to or higher than the threshold voltage of the MESFETs. Also, to sufficiently suppress current flow, it is preferable that the forward breakdown voltage of the Schottky barrier gate-diodes be substantially equal to the forward breakdown voltage of the Schottky barrier gate of the MESFETs of the transfer gate or the switching circuits. Furthermore, in order to reduce the number of fabricating steps and to increase production yield, it is preferably that the diodes and the Schottky barrier gates of the MESFETs be fabricated in the same processing steps.

The Schottky barrier gate diodes are preferably connected to the word lines or drive lines at a location as close to the first or second addressing circuits as possible. This location is preferable because the output voltage from the first or second addressing circuits drops along the length of the word lines or drive lines, which could result in data destruction and data read-out failure in some of the memory cells depending on the location and number of doides. This output voltage is applied to the diodes to decrease the current bypass effect of the diode when the diodes are located in the memory cell array.

The diodes used in the present invention differ from well known protecting diodes for preventing breakdown of MESFETs due to an over-voltage. While the present invention employs Schottky barrier gate diodes, protecting diodes normally comprise P-N junction diodes having excellent surge-resistant capability. In contrast to the normal arrangement of protecting diodes, the diodes of the present invention are located within the static RAM, whereas protecting diodes are normally located in the vicinity of a bonding pad on a peripheral portion of the substrate in order to protect transistors on the substrate.

Some embodiments of the present invention will now be described by way of example with reference to the accompanying drawings in which:

Figure 1 is a block diagram showing a basic construction of a static random-access memory device according to an embodiment of the present invention;

Figure 2 is a circuit diagram of a typical memory cell and the circuit for driving the memory cell in the static random-access memory device shown in Figure 1;

Figures 3(a) to 3(c) are enlarged cross-sectional views of two transistors and a diode forming the circuit arrangement of Figure 2;

Figures 4(a) to 4(c) are enlarged cross-sectional views of additional transistors and a diode forming the circuit arrangement of Figure 2; and

Figure 5 is a circuit diagram of a modification of a portion of the circuit arrangement illustrated in Figure 2.

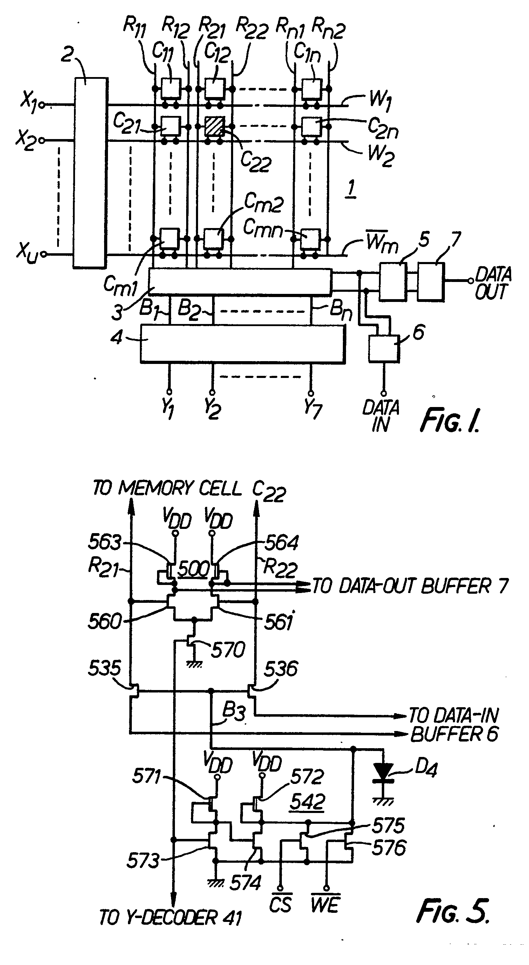

In Figure 1, a matrix of memory cell Cij (i=1 to m; j=1 to n, m and n being positive integers) is disposed on semi-insulating substrate 1 of gallium arsenide (GaAs). Each memory cell Cij is connected to word line Wi and a pair of bit lines Rji, Rj2. Word lines W1—Wm are connected to first addressing circuit (X-addressing circuit) 2 for selecting a designated memory cell according to coded X-address signals $X_I$-$X_U$. Bit lines R11—Rn1, R12—Rn2 are connected to switching circuit 3 for selecting the bit lines. Switching circuit 3 is controlled by second addressing circuit (Y-addressing circuit) 4 through drive lines B1—Bn. Second addressing circuit 4 selects a designated memory cell according to coded Y-address signals $Y_1$-$Y_V$.

Sense amplifier 5, which reads data out of memory cells C11—Cmn, and data input buffer 6, are connected to switching circuit 3. Sense amplifier 5 provides an output of data output buffer 7. Memory cells C11—Cmn, first and second addressing circuits 2 and 4, switching circuit 3, sense amplifier 5, data input buffer 6 and data output buffer 7 are formed together on the same substrate 1.

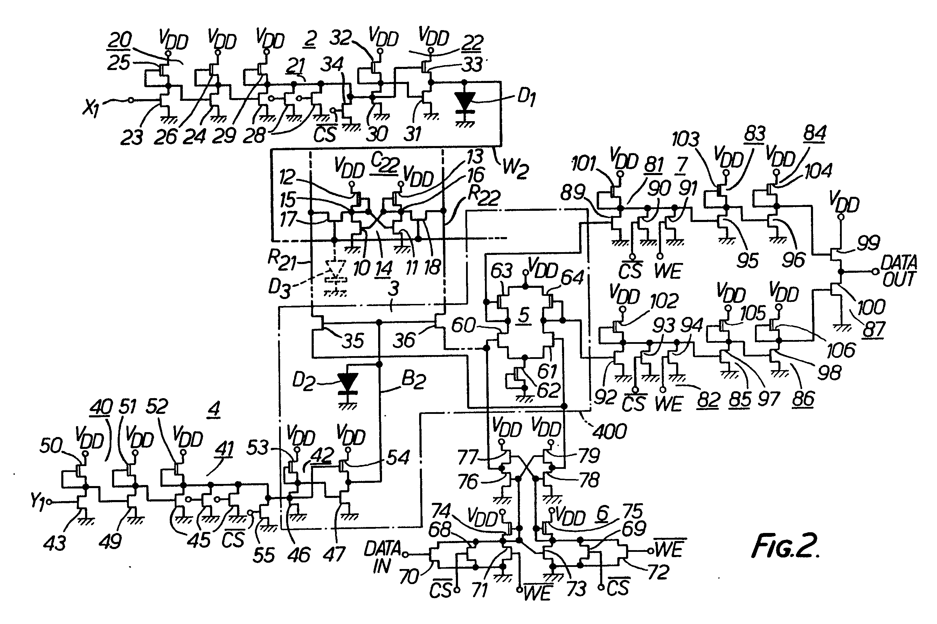

Figure 2 specifically illustrates one memory cell, i.e. memory cell C22, and its peripheral drive circuits. The other memory cells and their peripheral drive circuits have the same construction as shown in Figure 2. Memory cell C22 comprises flip-flop 14 formed by a pair of cross-coupled normally-off Schottky barrier gate field-effect switching transistors (MESFETs) 10 and 11, a pair of normally-on load MESFETs 12 and 13 connected to MESFETs 10 and 11, and a pair of transfer gates formed by normally-off MESFETs 17 and 18 connected between input/output nodes 15 and 16 of flip-flop 14 and bit lines R21 and R22.

First addressing circuit 2 comprises address buffer 20, decoder 21 and driver 22, all of which are known in the art. Address buffer 20, which includes normally-off MESFETs 23, 24 and normally-on MESFETs 25, 26, generate signal X1 or X1 in response to an X1 input. Decoder 21 comprises a NOR gate formed by a plurality of normally-off MESFETs 28, 34 and normally-on MESFET 29. The gates of MESFETs 28 receive signals from address buffer 20 and other address buffers of the same construction. Driver 22, which includes normally-off MESFETs 30, 31 and normally-on MESFETs 32, 33, supplies a sufficient driving current to word line W2.

Switching circuit 3 includes normally-off switching MESFETs 35, 36 connected to bit lines R21, R22, respectively. The gates of MESFETs 35 and 36 are connected in common to an output terminal of second addressing circuit 4 via drive line B2. Second addressing circuit 4 includes address buffer 40, decoder 41 and driver 42, all of which are known in the art. These elements of second addressing circuit 4 are formed by a combination of normally-off MESFETs 43—47, 55 and normally-on MESFETs 50—54 as shown in Figure 2.

Sense amplifier 5 is a known sense amplifier including a pair of normally-off switching MESFETs 60, 61, normally-on MESFET 62 connected between the sources of MESFETs 60, 61 and ground potential, and a pair of nromally-on MESFETs 63, 64 coupled to the drains of MESFETs 60, 61 respectively. Data input buffer 6 is a known circuit for supplying data to switching MESFETs 35, 36 when data is to be written into the memory device. Data input buffer 6 includes normally-off MESFET 70 for receiving data, a pair of normally-off MESFETs 71, 72 for receiving signal WE which is an inverted writing command signal, a pair of MESFETs 68, 69 for receiving signal CS which is an inverted chip select signal (described in further detail below), normally-off MESFET 73 driven by MESFET 70, and cross-coupled normally-off MESFETs 76—80. Data output buffer 7 includes a pair of NOR gates 81, 82, inverters 83—86, and output circuit 87, which comprises normally-off switching MESFETs 89—100 and normally-off load MESFETs 101—106. Signal CS is a signal for selecting a plurality of chips including the above static RAM and a common 2-volt power supply for supplying $V_{DD}$.

Schottky barrier gate diodes D1, D2 are connected in a forward bias direction between word line W2 and drive line B2 and ground potential. Diodes D1, D2 clamp the gate voltage of MESFET switches 35, 36 and MESFET transfer gates 17, 18 to about 0.8 V to prevent an overcurrent from flowing into the sources and drains of these MESFETs from word and drive lines W2, B2. For this purpose, diodes D1 and D2 preferably have a forward breakdown voltage which is equal to or higher than the threshold voltage (0.1—0.2 V) of MESFETs 17, 18, 35, 36, and which is substantially equal to the forward breakdown voltage (about 0.8 V, for example) of these MESFETs. Diode D1 may be connected to word line W2, for example, at a position D3 indicated by broken lines. In such an arrangement, however, a current is likely to flow into the sources or drains of the transfer gates of the memory cells which are located nearer to address circuit 2 than the position of diode D3. Similar diodes are connected to the other word lines W1, W3—Wm and drive lines B1, B3—Bn.

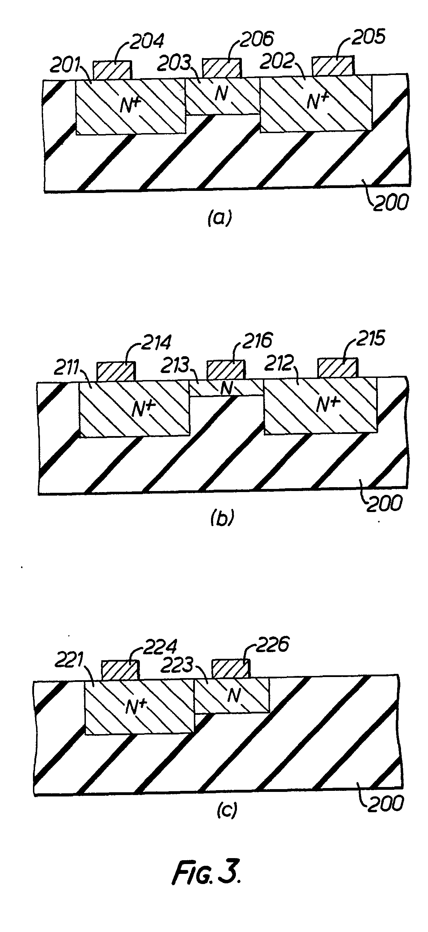

The construction of normally-on and normally-off MESFETs and a Schottky barrier gate diode of the aforementioned static RAM is illustrated in Figures 3(a) through 3(c). Figure 3(a) shows a normally-on MESFET fabricated on gallium arsenide substrate 200. N-conductive-type source and drain regions 201, 202 are formed by implanting silicon ions into substrate 200 having an impurity dose value of $3 \times 10^{13}$ cm$^{-2}$. N-conductive-type channel region 203 is formed by implanting silicon ions into substrate 200, for example, at an acceleration voltage of 100 KV with an impurity dose value of $3 \times 10^{12}$ cm$^{-2}$. Channel region 203 has a depth of about 0.2 μm. Electrodes 204, 205 of a gold-germanium alloy are disposed on the source and drain regions 201, 202, respectively, in ohmic contact therewith. Electrode 206 of aluminium is disposed on channel region 203. Electrode 206 forms a Schottky barrier together with channel region 203.

Figure 3(b) shows a normally-off MESFET fabricated on gallium arsenide substrate 200. The normally-off MESFET has course and drain regions 211, 212 which have the same construction as the source and drain regions 201, 202 shown in Figure 3(a), respectively. Electrodes 214, 215, 216 have the same construction as electrodes 204, 205, 206 shown in Figure 3(a), respectively. The normally-off MESFET has N-conductive-type channel region 213 of a construction different from that of channel region 203 of Figure 3(a). Channel region 213 is formed by implanting silicon ions into substrate 200 of an acceleration voltage of 50 KV with an impurity dose value of $1 \times 10^{13}$ cm$^{-2}$. Channel region 213 has a depth of about 0.1 μm. The Normally-off MESFET has a threshold voltage in the range of 0.1 to 0.2 V.

Figure 3(c) illustrates a Schottky barrier gate diode having N-conductive-type source region 221 and N-conductive type channel region 223 fabricated on gallium arsenide substrate 200. Electrode 224 of gold-germanium alloy is disposed on source region 221 in ohmic contact therewith. Electrode 226 of aluminium is disposed on channel region 223. Electrode 226 forms a Schottky barrier together with channel region 223. The diode has the same construction as the MESFET of Figure 3(a) except that the diode does not have drain region 202 and its corresponding electrode. The diode can therefore be fabricated easily and with a high production yield by utilising the fabrication process for the MESFET shown in Figure 3(a).

Various experiments carried out to confirm the advantages and results of the present invention will now be described. The ratios (W/L) of gate width (W) to gate length (L) of the MESFETs shown in Figure 2 were as follows:

W/L of MESFETs 10, 11:   20/1
W/L of MESFETs 12, 13:   4/8
W/L of MESFETs 17, 18:   10/1
W/L of MESFETs 35, 36:   50/1

The junction area of diodes D1, D2 5×5 (μm²), and power supply voltage $V_{DD}$ was 2 V. Data was written and stored in memory cell C22, and the potentials at nodes 15, 16 in Figure 2 were 0.1 V and 0.7 V, respectively. Thereafter, first and second addressing circuits 2, 4 were energised to enable transfer gates 17, 18 and switching MESFETs 35, 36 to read data out of memory cell C22 into sense amplifier 5. As a consequence, the potential of bit line R21 was about 0.2 V and the potential of bit line R22 was about 0.7 V, and the data could be read by an ordinary sense amplifier 5 without any difficulty. The data stored in memory cell C22 was not destroyed when word line W1 was set at a high level to read data out of another memory cell.

When data was read out of memory cell C22 with diodes D1 and D2 removed, a low level current flowed into node 15 through the gate of transfer gate 17 and the gate of switching MESFET 35, and thereby increased the potential of node 15 to about 0.5 V. At that time, a high level current also flowed into node 16 through the gate of transfer gate 18 and through the gate of switching MESFET 36. Since this current flowed from the gate to the source of MESFET 10, the potential of node 16 remained substantially unchanged at about 0.8 V. As a result, the potential of bit lines R21, R22 was about 0.7 V, and data could not be read by sense amplifier 5. When word line W1 was set at a high level to read data out of another memory cell, the data stored in memory cell C22 was destroyed by a slight external disturbance such as a change in the power supply voltage. This data destruction was caused by the small difference between the potential of the low level node 15 and high level node 16.

To the contrary, when power supply voltage $V_{DD}$ was set to 1 V with diodes D1, D2 removed, the date was not destroyed and could be read out of memory cell C22.

Further experiments were carried out using only one of the diodes D1, D2. When first and second addressing circuits 2, 4 were energised with diode D1 connected and diode D2 removed, node 15 was at a potential of 0.15 V and node 16 at a potential of 0.7 V. The potentials of bit lines R21, R22 were 0.5 V and 0.7 V, respectively. The data could then be read out of memory cell C22, because sense amplifier 5 had a sufficient sensitivity. When word line W2 was set at a high level for reading data out of another memory cell, data destruction did not take place in memory cell C22.

When first and second addressing circuits 2, 4 were energised with diode D2 connected and diode D1 removed, node 15 was at a potential of .0.3 V and node 16 at a potential of 0.5 V. The potentials of bit lines R21, R22 were 0.4 V and 0.6 V, respectively. The data could be read out of memory cell C22 because sense amplifier 5 had sufficient sensitivity. When word line W2 was set at a high level for reading data out of another memory cell, and when the external disturbances were small, then the data in memory cell C22 was not destroyed. Therefore, it is apparent from the above experimental results that the use of at least one of diodes D1, D2 is required for stable memory operation.

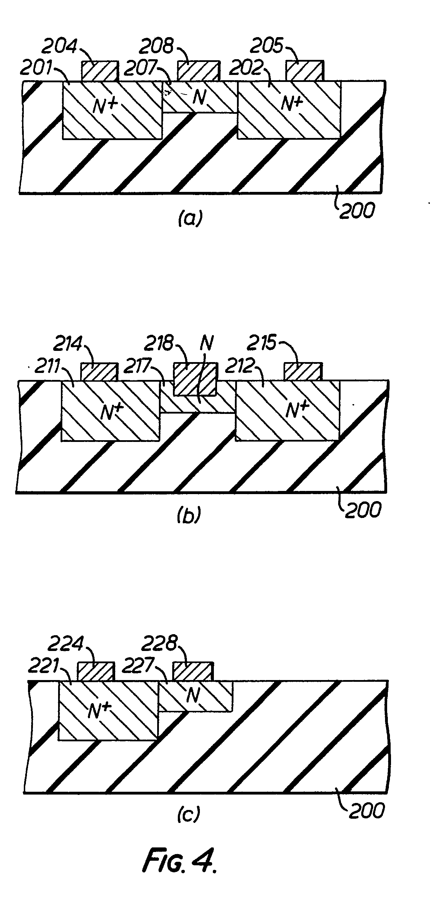

While the normally-on and normally-off MESFETs and the Schottky barrier gate diode illustrated in Figures 3(a) through 3(c) were employed in the foregoing embodiment, those shown in Figures 4(a) through 4(c) may also be used. The same parts in Figures 3(a) through 3(c) and Figures 4(a) through 4(c) are denoted by identical reference characters. The construction of the channel regions and electrodes disposed therein of the elements in Figures 4(a) through 4(c) is different than Figures 3(a) through 3(c). Channel regions 207, 217, 227 shown in Figures 4(a) thorugh 4(c) have a substantially equal depth of about 0.2 μm. Also, in the normally-on MESFET shown in Figure 4(a), gate electrode 208 is made of platinum. The normally-off MESFEET shown in Figure 4(b) has a platinum gate electrode 213 buried in channel region 217 by a heat treating process. The diode illustrated in Figure 4(c) has a platinum electrode 228 disposed on channel region 227.

A modified circuit arrangement, as shown in Figure 5, may be employed in place of circuit arrangement 400 enclosed by the dot-dash line in Figure 2. In the circuit arrangement of Figure 5, sense amplifier 500 is connected to bit lines R21, R22 between memory cell C22 and switching circuit MESFETs 535, 536 for selecting bit lines. Sense amplifier 500 incudes switching MESFETs 560, 561, 570 and load MESFETs 563, 564. Address buffer 542 is formed by normally-off switching MESFETs 573—576 and normally-on load MESFETs 571, 572. Schottky barrier gate diode $D_4$ is connected between ground potential and drive line $B_3$, which supplies an output signal from address output buffer 542 to the gates of MESFETs 535, 536. Schottky barrier gate diode $D_4$ is connected in a forward bias direction to clamp the output signal. In the circuit arrangement of Figure 5, a sense amplifier is necessary for each pair of bit lines. On the other hand, in the circuit arrangement of Figure 2, all of bit lines R11—Rn1, R12—Rn2 can be connected in common to one sense amplifier 5.

**Claims**

1. A static random-access memory device which is formed on a gallium arsenide substrate comprising:

(a) a plurality of memory cells ($C_{11}$—Cmn) connected in a matrix by bit lines ($R_{11}$—$Rn_1$, $R_{12}$—$Rn_2$) and word lines ($W_1$—Wm) each memory cell ($C_{22}$) including a flip-flop (14) having a pair of input/output nodes and a pair of cross-coupled normally-off Schottky barrier gate field-effect transistors (10, 11) connected to said input/output nodes, said memory cell further including a pair of transfer gates fromed by normally-off Schottky barrier gate field-effect transistors (17, 18) having their gates connected to said word lines and their sources and drains connected between said input/output nodes of said flip-flop and said bit lines;

(b) first addressing circuit means (2) for supplying control signals to said transfer gates through said word lines;

(c) data input means (6) for writing data into said memory cells through said bit lines;

(d) data output means (7) for reading data out of said memory cells through said bit lines;

(e) switching means formed by normally-off Schottky barrier gate field-effect transistors (35, 36) for selecting said bit lines;

(f) second addressing circuit means (4) for supplying control signals through drive lines to said switching means; and

(g) a first Schottky barrier gate diode (D₁) connected in a forward bias direction between at least one of said word lines and a reference potential to clamp the gate voltage on the gates of said Schottky barrier gate field-effect transistors forming said transfer gates;

characterised in that the memory device further comprises:

(h) a second Schottky barrier gate diode ($D_2$, $D_4$) connected in a forward bias direction between at least one of said drive lines ($B_2$, $B_3$) and said reference potential to clamp the gate voltage on the gates of said Schottky barrier gate field-effect transistors forming said switching means.

2. A static random-access memory device according to claim 1 wherein said first diode has a forward breakdown voltage which is equal to or higher than the threshold voltage of said transistors constituting said transfer gates and said switching means, and which is substantially the same as the forward breakdown voltage of the Schottky barrier gates of said transistor.

3. A static random-access memory device according to claim 1 or claim 2 wherein at least one of said first and second addressing circuit means comprises Schottky barrier gate field-effect transistors.

4. A static random-access memory device according to any preceding claim further comprising a common power supply to supply a positive voltage to said flip-flop and said first and second addressing circuit means, said reference potential being a ground potential.

5. A static random-access memory device according to any preceding claims wherein said data output means comprises a sense amplifier connected through said switching means to said memory cells and an output buffer to receive an output signal from said sense amplifier.

6. A static random-access memory device according to any of claims 1 to 4, wherein said data output means comprises a sense amplifier connected to said bit lines between one of said memory cells and said switching means and an output buffer to receive an output signal from said sense amplifier.

7. A static random-access memory device according to any preceding claim wherein said first Schottky barrier gate diode is connected to said word line in close proximity to said first or second addressing circuit means.

**Patentansprüche**

1. Statischer Speicher mit wahlfreiem Zugriff, der auf einem Galliumarsenid-Substrat ausgebildet ist, mit:

(a) einer Mehrzahl von Speicherzellen ($C_{11}$—$C_{mn}$), die in einer Matrix durch Bitleitungen ($R_{11}$—$R_{n1}$, $R_{12}$—$R_{n2}$) und Wortleitungen ($W_1$—$W_m$) verbunden sind, wobei jede Speicherzelle ($C_{22}$) ein Flip-Flop (14) enthält, das ein Paar von Eingabe/Ausgabe-Knoten und ein Paar über Kreuz gekoppelter, selbstsperrender Schottky-Gate-Feldeffekttransistoren (10, 11) verbunden mit den Eingabe/Ausgabe-Knoten aufweist, wobei jede Speicherzelle ein Paar von Übertragungsschaltern enthält, die durch selbstsperrende Schottky-Gate-Feldeffekttransistoren (17, 18) gebildet werden, deren Gates an die Wortleitungen angeschlossen sind und die über Source und Drain die Eingabe/Ausgabe-Knoten des Flip-Flops und die Bitleitungen verbinden;

(b) ersten Adressierungsschaltungsmitteln (2) zur Lieferung von Steuersignalen über die Wortleitungen zu den Übertragungsschaltern;

(c) Dateneingabemitteln (6) zum Einschreiben von Daten in die Speicherzellen über die Bitleitungen;

(d) Datenausgabemitteln (7) zum Auslesen von Daten aus den Speicherzellen über die Bitleitungen;

(e) Schaltmitteln, die durch selbstsperrende Schottky-Gate-Feldeffektransistoren (35, 36) gebildet werden, zum Auswählen der Bitleitungen;

(f) zweiten Adressierungsschaltungsmitteln (4) zur Ausgabe von Steuersignalen für die Schaltmittel über Steuerleitungen; und

(g) einer ersten Schottky-Diode ($D_1$), die in Durchlaßrichtung zwischen wenigstens einer der Wortleitungen und einem Bezugspotential liegt, um die Gate-Spannung der Schottky-Gate-Feldeffekttransistoren zu begrenzen, die als Übertragungsschalter dienen;

dadurch gekennzeichnet, daß der Speicher weiterhin aufweist:

(h) eine zweite Schottky-Diode ($D_2$, $D_4$), die in Durchlaßrichtung zwischen wenigstens einer der Steuerleitungen ($B_2$, $B_3$) und dem Bezugspotential liegt, um die Gate-Spannung der Schottky-Gate-Feldeffektransistoren zu begrenzen, die als Schaltmittel dienen.

2. Statischer Speicher nach Anspruch 1, wobei die Durchlaßspannung der ersten Schottky-Diode gleich oder größer ist als die Schwellenspannung der Transistoren, die die Übertragungsschalter und die Schaltmittel bilden, und im wesentlichen gleich der Durchlaßspannung der Schottky-Dioden in den Transistoren ist.

3. Statischer Speicher nach Anspruch 1 oder 2, wobei wenigstens eines der ersten und zweiten Adressierungsschaltungsmittel Schottky-Gate-Feldeffektransistoren enthält.

4. Statischer Speicher nach jedem der vorhergehenden Ansprüche, der eine gemeinsame Spannungsversorgung aufweist, um eine positive Spannung an das Flip-Flop und das erste und zweite Adressierungsschaltungsmittel zu liefern, wobei das Bezugspotential das Erdpotential ist.

5. Statischer Speicher nach jedem der vorhergehenden Ansprüche, wobei die Datenausgabemittel einen Leseverstärker, der über die Schaltmittel mit den Speicherzellen verbunden ist, und einen Ausgangstreiber aufweisen, der die Ausgabesignale des Leseverstärkers aufnimmt.

6. Statischer Speicher nach jedem der Ansprüche 1 bis 4, wobei die Datenausgabemittel einen Leseverstärker, der mit den Bitleitungen zwischen einer der Speicherzellen und den Schaltmitteln verbunden ist, und ein Ausgangstreiber aufweisen, der die Ausgabesignale des Leseverstärkers aufnimmt.

7. Statischer Speicher nach jedem der vorhergehenden Ansprüche, wobei die erste Schottky-Diode mit der Wortleitung in nächster Nähe zu den ersten oder zweiten Adressierungsschaltungsmitteln verbunden ist.

## Revendications

1. Dispositif de mémoire statique à accès aléatoire ou direct formé sur un substrat d'arséniure de gallium, qui comprend:

a) un certain nombre de cellules de mémoire ($C_{11}$—Cm) connectées en une matrice par des lignes de bits ($R_{11}$—$Rn_1$) et des lignes de mots $W_1$—Wm), chaque cellule de mémoire ($C_{22}$) incluant une bascule (14) ayant une paire de noeuds d'entrée et de sortie et une paire de transistors à effet de champ à barrière de Schottky (10, 11) normalement non-conducteurs ou bloqués couplés en croix, qui sont connectés auxdits noeuds d'entrée et de sortie, ladite cellule de mémoire incluant, en outre, deux portes de transfert formées par des transistors à effet de champ à barrière de Schottky normalement non-conducteurs ou bloqués (17, 18) dont les portes sont connectées auxdites lignes de mots, tandis que leurs sources et leurs drains sont branchés entre lesdits noeuds d'entrée et de sortie desdites bascules et lesdites lignes de bits;

b) un premier circuit d'adressage (2) pour fournir des signaux de commande auxdites portes de transfert par lesdites lignes de mots;

c) des moyens d'entrée de données (6) pour écrire des données dans lesdites cellules de mémoire par lesdites lignes de bits;

d) des mmyens de sortie de données (7) pour lire des données dans lesdites cellules de mémoire par lesdites lignes de bits;

e) des moyens de commutation formés par des transistors à effet de champ à porte à barrière de Schottky (35, 36) pour sélectionner lesdites lignes de bits;

f) un second circuit d'adressage (4) pour fournir des signaux de commande par les lignes d'actionnement auxdits moyens de commutation; et

g) une première diode à porte à barrière de Schottky ($D_1$) connectée, en polarisation directe, entre l'une, au moins, desdites lignes de mots, et un point de potentiel de référence, afin de bloquer ou de clamper la tension de porte des portes desdits transistors à effet de champ à porte à barrière de Schottky formant lesdites portes de transfert, caractérisé par:

h) une seconde diode à barrière de Schottky ($D_2$, $D_4$) connectée en polarisation directe entre l'une, au moins, desdites lignes d'actionnement ($B_2$, $B_3$) et ledit potentiel de référence, afin de bloquer la tension de port des portes desdits transistors à effet de champ à porte à barrière de Schottky formant lesdits moyens de commutation.

2. Dispositif de mémoire à accès aléatoire ou direct selon la revendication 1, caractérisé en ce que ladite première diode a une tension de percement ou de claquage en sens direct égale ou supérieure à la tension de seuil des transistors constituant lesdites portes de transfert et lesdits moyens de commutation, et qui est sensiblement égale à la tension de percement ou de claquage en sens direct de la barrière de Schottky desdits transistors.

3. Dispositif de mémoire à accès aléatoire ou direct selon la revendication 1 ou 2, caractérisé en ce que, au moins, le premier et/ou le second circuit d'adressage comprennent des transistors à effet de champ à barrière de Schottky.

4. Dispositif de mémoire à accès aléatoire ou direct selon l'une quelconque des revendications précédentes, caractérisé en ce qu'il comprend une alimentation électrique commune pour fournir une tension positive à ladite bascule et auxdits premiers et seconds circuits d'adressage, ledit potentiel de référence étant celui de la masse.

5. Dispositif de mémoire à accès aléatoire ou direct selon l'une quelconque des revendications précédentes, caractérisé en ce que lesdits moyens de sortie de données comprennent un amplificateur-senseur connecté par lesdits moyens de commutation auxdites cellules de mémoire, et un circuit tampon de sortie pour recevoir un signal de sortie dudit amplificateur.

6. Dispositif de mémoire à accès aléatoire ou direction selon l'une quelconque des revendications 1 à 4, caractérisé en ce que lesdits moyens de sortie de données comprennent un amplificateur-senseur connecté auxdites lignes de bits entre l'une desdites cellules de mémoire et lesdits moyens de commutation, et un circuit tampon de sortie pour recevoir un signal de sortie dudit amplificateur.

7. Dispositif de mémoire à accès aléatoire ou direct selon l'une quelconque des revendications précédentes, caractérisé en ce que ladite première diode à barrière de Schottky est connectée à ladite ligne de mots, à proximité immédiate, desdits premiers et seconds circuits d'adressage.

*Fig. I.*

*Fig. 5.*

Fig.2.

FIG. 3.

FIG. 4.